# EUROPEAN PATENT APPLICATION

(11) **EP 4 550 396 A2**
(43) Date of publication of application: **07.05.2025**
(21) Application number: 24208358.2
(22) Date of filing: 23.10.2024
(51) Int. Cl.: H01L 21/762

(54) **STRUCTURE AND METHOD OF FORMING LOW-COST THICK SOI WAFER**

(30) Priority: 02.11.2023 US 202318500320
(71) Applicant: Semiconductor Components Industries, LLC, Scottsdale, AZ 85250 (US)
(72) Inventor: PJENCAK, Jaroslav, 75655 Dolni Becva (CZ); HYBL, Jan, 75654 Zubri (CZ); POSTULKA, Dusan, 70030 Ostrava (CZ); JARINA, Juraj, 01501 Rajec (SK); LYSACEK, David, 75651 Sasova, Vidce (CZ)
(74) Representative: Manitz Finsterwald Patent- und Rechtsanwaltspartnerschaft mbB

(57) **Abstract**

A semiconductor substrate includes a handle wafer, an oxide layer formed on the handle wafer, and a device layer formed or disposed on the oxide layer. The device layer includes a first epitaxial silicon layer bonded to the oxide layer formed on the handle wafer, a layer of compensated silicon crystalline material formed or disposed on the first epitaxial silicon layer, and a second epitaxial silicon layer formed on the layer of compensated silicon crystalline material. The compensated silicon crystalline material includes a Czochralski silicon substrate.

## Description

### TECHNICAL FIELD

This disclosure relates, in general, to electronics and, more particularly, to methods of forming semiconductor devices and semiconductor device structures.

### BACKGROUND

A silicon-on-insulator (SOI) substrate or wafer is a semiconductor structure consisting of a layer of single crystalline silicon (SOI layer) separated from a bulk substrate by a thin layer of insulator. SOI wafers can be fabricated, for example, using wafer bonding or ion implantation technologies. In SOI wafers, the insulator is almost invariably a thermal silicon oxide (SiO₂) layer, and the substrate is a silicon wafer. Depending on the type of application, the layer of single crystalline silicon can be very thin (e.g., <50 nm for fully depleted transistors used in high-speed submicron ULSI applications), or it can be tens of micrometers thick. SOI layer thicknesses of 1 µm and above are classified as thick-film SOI. Device types that can be fabricated on thick SOI wafers include bipolar devices used, for example, in high voltage and smart power applications, and MEMS. Modem smart power applications drive semiconductor device and circuit technologies (e.g., Bipolar-CMOS-DMOS (BCD) technologies) to higher voltage nodes (e.g., greater than 100 V), lower costs and higher isolation requirements. Toward these goals, BCD devices and circuits can be fabricated on SOI substrates (e.g., on a thick SOI substrate).

### SUMMARY

In a general aspect, a semiconductor substrate includes a handle wafer, an oxide layer disposed on the handle wafer, and a device layer disposed on the oxide layer. The device layer includes a first epitaxial silicon layer bonded to the oxide layer, a layer of compensated silicon crystalline material disposed on the first epitaxial silicon layer, and a second epitaxial silicon layer disposed on the layer of compensated silicon crystalline material. The compensated silicon crystalline material includes a Czochralski silicon substrate.

In a general aspect, a semiconductor substrate includes a handle wafer, an oxide layer disposed on the handle wafer, and a device layer disposed on the oxide layer. The device layer includes a layer of compensated silicon crystalline material. The compensated silicon crystalline material includes a Czochralski silicon substrate.

In a general aspect, a method includes forming an oxide layer on a surface of a handle wafer and forming a first device material layer on a surface of a support wafer, the support wafer being a Czochralski-grown silicon substrate. The method further includes bonding the first device material layer on the surface of the support wafer to the oxide layer formed on the surface of a handle wafer to form an assembly including the support wafer and the handle wafer. The method further includes removing a portion of the support wafer to reduce a thickness of the support wafer in the assembly, and forming a second device material layer on a top surface of the support wafer in the assembly.

### BRIEF DESCRIPTION OF THE DRAWINGS

FIG. 1 schematically illustrates, in a cross-sectional view, a silicon-on-insulator (SOI) substrate.
FIG. 2 schematically illustrates, in a cross-sectional view, another SOI substrate.
FIG. 3 illustrates a flow chart for an example method for assembling a thick SOI substrate.
FIGS. 4A through 4G illustrate cross-sectional views of a thick SOI substrate at various stages of construction or assembly.

In the drawings, which are not necessarily drawn to scale, like reference symbols and or alphanumeric identifiers may indicate like and/or similar components (elements, structures, etc.) in different views. The drawings illustrate, by way of example, but not by way of limitation, various implementations discussed in the present disclosure. Reference symbols and or alphanumeric identifiers shown in one drawing may not be repeated for the same and/or similar elements in related views in other drawings. Reference symbols and or alphanumeric identifiers that are repeated in multiple drawings may not be specifically discussed with respect to each of those drawings but are provided for convenience in cross reference between related views. Also, not all like elements in the drawings are specifically referenced with a reference symbol and or an alphanumeric identifier when multiple instances of an element are illustrated.

### DETAILED DESCRIPTION

The present disclosure is directed to a structure of a silicon-on-insulator (SOI) substrate and a method for fabricating the same. The SOI substrate may be a bonded thick SOI wafer. At least a portion of the device layer of the SOI substrate is composed of non-epitaxial silicon crystalline material (e.g., silicon crystalline material grown from a silicon melt by a Czochralski (CZ) method). Using non-epitaxial silicon crystalline material grown by the Czochralski method in the device layer can reduce the costs of fabricating a thick SOI substrate compared to the costs of fabricating a thick SOI with an all-epitaxially grown device layer.

In the manufacture of silicon substrates, electronic grade polysilicon is used to grow single crystal silicon by CZ crystal growth or float zone (FZ) crystal growth. In CZ crystal growth, single crystal ingots are pulled from molten silicon contained within a crucible. In FZ crystal growth, a floating zone of melt (that is, a molten zone) is formed between a single crystal seed and a polycrystalline rod by, for example, RF heating. The zone is moved along the length of the rotating polycrystalline rod to produce a single crystal ingot of approximately the same dimensions as the polycrystalline rod. A crucible is not used in the FZ process, so the silicon does not come into contact with any substance other than ambient gas in a growth chamber. Thus, FZ crystals have higher inherent purity than CZ crystals. In addition, FZ substrates can be manufactured with narrower dopant or resistivity profiles, lower oxygen content, and with lower occurrences of crystal originated particles (COPs) compared to typical CZ substrates.

Some power semiconductor devices require high purity silicon substrates and thus FZ silicon substrates are often the material of choice. However, FZ substrates are more expensive to manufacture than CZ substrates and FZ substrates are not available at larger diameters, such as 300 millimeters (mm). CZ substrates are available in larger diameters including 300 mm substrates.

A method is described that provides CZ semiconductor substrates that have characteristics similar to FZ semiconductor substrates. This includes, for example, low oxygen concentration and improved radial resistivity variation. Also, the method provides semiconductor substrates having larger diameters (≥ 200 mm) than are available for FZ semiconductor substrates. In addition, the method provides significantly reduced COP defect concentration compared to previous CZ semiconductor substrates.

A method and structure for manufacturing a CZ semiconductor substrate includes manufacturing a CZ semiconductor ingot with magnetic CZ crystal growth and continuous counter-doping. The method includes exposing unpolished CZ semiconductor substrates from the CZ semiconductor ingot to a first annealing to dissolve inner wall oxides from voids within the CZ semiconductor substrates. The method includes a second annealing that provides silicon interstitials to form a COP free zone within the CZ semiconductor substrates. The method provides CZ semiconductor substrates with reduced oxygen concentration, improved radial resistivity variation, and reduced COP defects. In addition, the method produces CZ semiconductor ingots with reduced axial resistivity variation, which improves utilization. The CZ semiconductor substrates of the present description comprise characteristics similar to FZ semiconductor substrates at significantly lower cost (for example, 50% less in some cases).

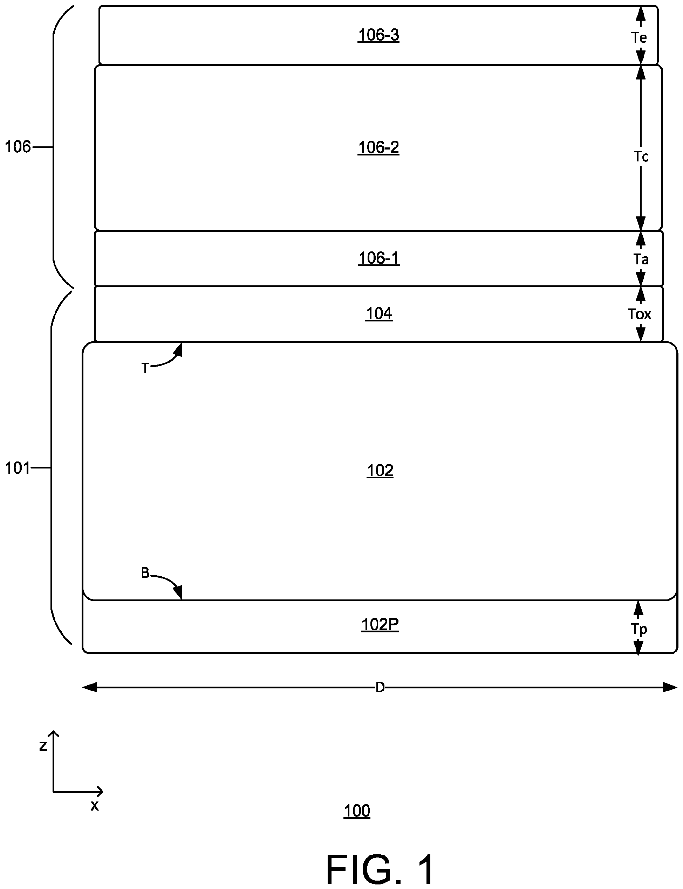

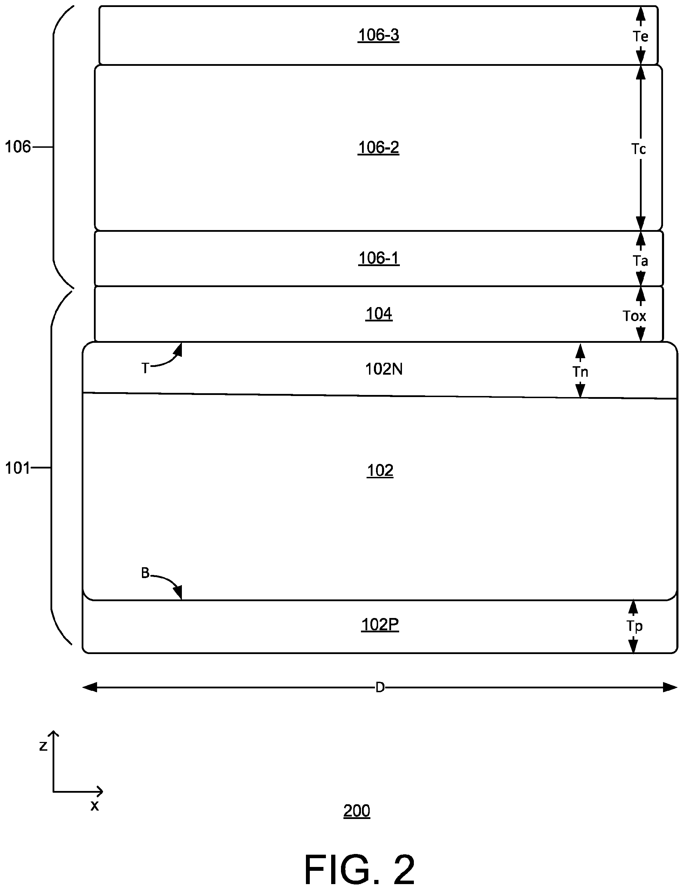

FIG. 1 and FIG. 2 show, in cross-sectional views, an example SOI substrate 100 and an example SOI substrate 200, respectively, in accordance with the principles of the present disclosure.

SOI substrate 100 may include a silicon material device layer (e.g., device layer 106) formed on top of a handle wafer 101. Device layer 106 includes epitaxial silicon material (e.g., layer 106-1 and layer 106-3) and non-epitaxial silicon crystalline material (e.g., layer 106-2).

In SOI substrate 100, handle wafer 101 includes a silicon wafer (e.g., silicon wafer 102) having an insulator layer (e.g., buried oxide layer (BOX) 104, silicon dioxide) formed on a top surface T of the silicon wafer. The insulator layer (e.g., BOX 104), which can be a thermally grown oxide layer, electrically isolates the silicon material device layer (e.g., device layer 106) from silicon wafer 102. Handle wafer 101, which provides structural or mechanical support for the SOI wafer in device processing operations, can include a protective double polysilicon layer (e.g., layer 102P) formed on a back surface B of silicon wafer 102. Layer 102P can prevent or eliminate formation of epi nodule defects when the SOI substrate is processed further (e.g., in epitaxial growth processes) for substrate preparation or for device fabrication. In an example implementation, layer 102P may have a thickness Tₚ in a range of about 0.8 µm to 1.2 µm.

In example implementations, the silicon material device layer (e.g., device layer 106) includes an epitaxially-grown silicon layer (e.g., layer 106-1) formed or disposed on BOX 104, a non-epitaxial silicon crystal layer (e.g., layer 106-2) formed on layer 106-1, and another epitaxially-grown silicon layer (e.g., layer 106-3) formed on layer 106-2.

The non-epitaxial silicon crystal layer (e.g., layer 106-2) may include silicon material of a Czochralski substrate (in other words, include silicon material grown, e.g., by a magnetic Czochralski method). Layer 106-2 may include compensated silicon material of high purity grown by the magnetic Czochralski method. The compensated silicon material grown by the magnetic Czochralski method can be substantially defect free, exhibit little or no resistivity variations and have few if any crystal originated particle (COP) defects. In example implementations, layer 106-2 may be a Czochralski silicon substrate that is substantially COP free (e.g., have a COP density <1 COPs @ 0.06 um/cm².). In example implementations, the Czochralski silicon substrate has a radial resistivity variation (rrv) of less than 3.5 %.

In example implementations, the Czochralski silicon substrate with low radial resistivity variation (rrv) may be p-doped material compensated with an n-type counter dopant (e.g., phosphorus).

In example implementations, the handle wafer 101 (e.g., silicon wafer 102) may be a silicon wafer of any dopant type (e.g., a n-type silicon wafer or a p-type silicon wafer). Silicon wafer 102 may be a silicon wafer of any standard diameter D (e.g., D = 100 mm, 125 mm, 200 mm, 300 mm, etc.) that can be processed, for example, through the wafer-size dependent equipment of a semiconductor device fabrication line. In some example implementations, silicon wafer 102 may be a silicon wafer with an industry standard diameter D of about 200 mm. Silicon wafer 102 may, for example, include Czochralski monocrystalline silicon material (CZ material). Silicon wafer 102 may, for example, be a p-type wafer with a resistivity in a range of 0.5 Ω.cm to 20 Ω.cm (e.g., 0.5 Q.cm to 12 Ω.cm). In example implementations the Czochralski monocrystalline silicon material (CZ material) may be counter doped with an n dopant (e.g., phosphorus). Oxygen concentration in the Czochralski monocrystalline silicon material of silicon wafer 102 may be 50 parts per million atoms (ppma) or less (e.g., below 24 ppma).

In some example implementations of the SOI substrate (e.g., SOI substrate 200 shown in FIG. 2), silicon wafer 102 may be a p-type doped wafer. An n-doped layer (e.g., n-doped layer 102N may be formed along front side F in the silicon wafer next to the insulator layer (e.g., below BOX 104). In example implementations, the n-doped layer 102N may be formed by epitaxy or by ion implantation.

In example implementations, n-doped layer 102N may have a doping concentration in a range of about 1 E¹⁵ to 1 E¹⁷ atoms/cm³ and a thickness Tn in a range of about 1 µm to 5 µm. The n-doped layer 102N disposed or formed below BOX 104 can reduce substrate capacitance (C_{sub}) for devices and circuits that may be fabricated in or on SOI substrate 200.

In some example implementations of the SOI substrate, as shown in both FIG. 1 and FIG. 2, the insulator layer (e.g., BOX 104) may be an oxide layer that is thermally grown on a top surface T of silicon wafer 102. In example implementations, BOX 104 may have a thickness Tox between 200 nm and 2000 nm (e.g., - 730 nm).

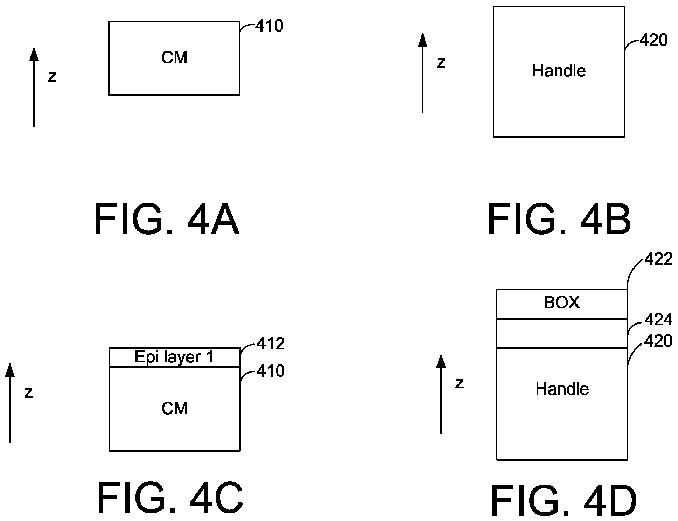

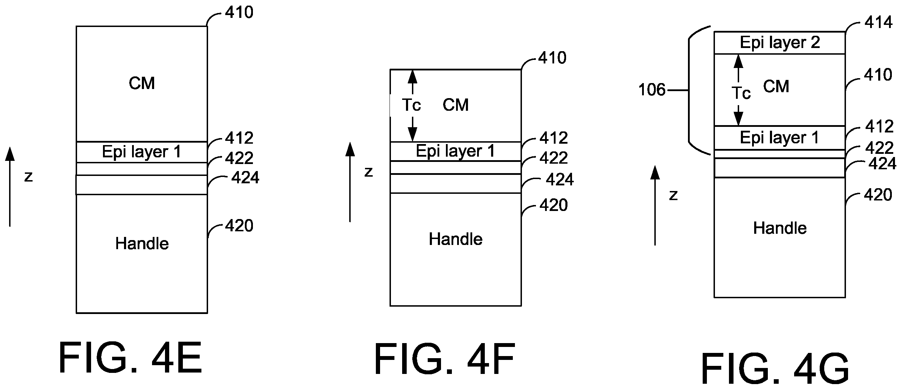

In some example implementations of the SOI substrates (e.g., SOI substrate 100 and SOI substrate 200, as shown respectively in FIG. 1 and FIG. 2), device layer 106 includes an epitaxially-grown silicon layer (e.g., layer 106-1) formed on BOX 104. Layer 106-1 may be grown on another silicon wafer (e.g., the support wafer 410 of FIG. 4A, layer 106-2, etc.) and transferred to SOI substrate 100 or SOI substrate 200 above BOX 104, for example, by a wafer-wafer bonding process.

Layer 106-1 may have a thickness Tₐ of about 2 to 5 microns. Further, layer 106-1 may have a resistivity that is different than the resistivity of layer 106-2. Layer 106-1 may be doped during epitaxial growth or by ion implantation at a later stage. Layer 106-1 may have a dopant concentration in a range of about 5 E¹⁵ to 1 E¹⁷ atoms.cm⁻³. In an example implementation, layer 106-1 may have a thickness Tₐ = 3 µm +/-0.4 µm and a resistivity = 1.42 +/- 0.2 Ω.cm.

In example implementations, for a device and other circuits fabricated in layer 106, layer 106-1 may function as an anti-back gate (ABG) layer formed on BOX 104. The ABG layer may be useful in shielding the device and other circuits (not shown) formed in or on layer 106 from a potential of silicon wafer 102.

Further, as previously noted, the non-epitaxial silicon crystal layer (e.g., layer 106-2) formed or disposed on layer 106-1 is formed of silicon material grown from a melt by an enhanced (e.g., magnetic) Czochralski method. The layer 106-2 can be grown as part of a CZ substrate (not shown) and transferred to SOI substrate 100 above layer 106-1, for example, by a wafer-wafer bonding process. In example implementations, layer 106-2 may have a thickness T_{c}, which can be in a range of, for example, 5 µm to 100 µm. In some example implementations, T_{c} may be about 10 µm +/- 0.4 µm. In some example implementations, layer 106-2 may have a resistivity = 25 +/- 2.5 ohm.cm and, for a 200 mm diameter substrate, a radial resistivity variation that is below 5%.

The non-epitaxial silicon crystal layer (e.g., layer 106-2) obtained by the Czochralski method may have a material quality comparable to that of epitaxial silicon. In example implementations, the non-epitaxial silicon crystal layer (e.g., layer 106-2) obtained by the Czochralski method may have a same (or comparable) COP density as the COP density of silicon substrates grown by a float zone method. The non-epitaxial silicon crystal layer may be formed of compensated semiconductor material (in other words, a material with a number of donors approximately equal to a number of acceptors so that the semiconductor behaves almost intrinsically). Layer 106-2 may have a thickness between 8 µm and 12 µm (e.g., about 10 µm).

In SOI substrate 100, layer 106-3 includes silicon epitaxial material that is grown on top of the Czochralski silicon material in layer 106-2. The silicon epitaxial material in layer 106-3 can be an active area for devices and circuits fabricated in or on a thick SOI substrate (e.g., SOI substrate 100). In example implementations, layer 106-3 may have a thickness Tₑ in a range of about 2 µm to 7.0 µm (e.g., 4 µm +/- 0.5 µm).

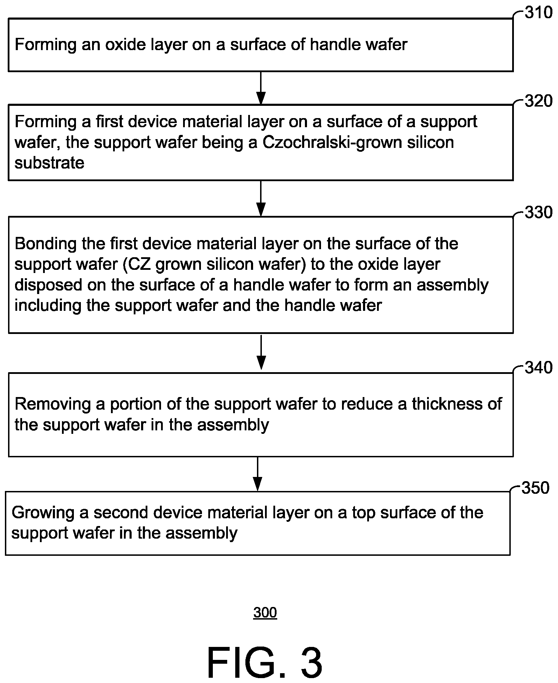

FIG. 3 shows a flow chart for an example method 300 for assembling a thick silicon-on-insulator (SOI) substrate (e.g., SOI substrate 100). The method may involve at least one wafer-wafer bonding step, at least one grinding and polishing step, and at least an epitaxial growth step.

Method 300 includes forming an oxide layer on a surface of handle wafer (310) and forming a first device material layer on a surface of a support wafer (320).

The handle wafer may be a silicon substrate (e.g., a ≥ 200 mm diameter silicon wafer). The handle wafer may, for example, be a p-type doped wafer, with a resistivity in a range of 5 to 12 ohm.cm. The handle wafer may have a boron dopant concentration in a range of about 2.7 E⁺¹⁵ to 1.1 E⁺¹⁵ atoms/cm³. The oxide layer formed on the handle wafer may, for example, be an oxide layer that is thermally grown on a top surface of the handle wafer.

In some example implementations, the handle wafer (e.g., a p-doped substrate) may further include an n-doped layer (e.g., layer 102N, FIG. 2). This layer may be formed by epitaxy or by ion implantation. The n-doped layer may have a doping concentration in a range of about 1 E¹⁵ to 1 E¹⁷ atoms/cm³ and a thickness Tn in a range of about 1 µm to 5 µm. Forming an oxide layer on a handle wafer 310 may include forming the oxide layer on a n-doped layer at the surface of the handle wafer.

The support wafer may, for example, be a Czochralski grown silicon wafer. In example implementations, the support silicon wafer may be a p-type silicon substrate (e.g., a ≥ 200 mm diameter silicon wafer) doped with, for example, boron. The dopant concentration may, for example, be about 5 E¹⁴ atoms/cm³. The first device material layer (e.g., layer 106-1, FIG. 1) formed on the surface of the support silicon wafer may be an epitaxially grown layer of silicon. The first device material layer may, for example, be a p-doped silicon layer with a dopant concentration (e.g., boron) of about 1 E⁺¹⁶ atoms/cm⁺³. In an example implementation, the first device material layer may have a resistivity of 1 few Ω.cm (e.g., about 1.42 Ω.cm +/-0.2 Ω.cm), and a thickness of about 1 µm to 7 µm (e.g., 3.0 µm +/- 0.4 µm).

Method 300 further includes bonding the first device material layer on the surface of the support wafer (e.g., a CZ grown silicon wafer) to the oxide layer formed on the surface of a handle wafer to form an assembly including the support wafer and the handle wafer (330). This bonding (e.g., wafer-to-wafer bonding) may involve placing the support wafer upside down on the handle wafer so that the first device material layer is aligned with, and in contact with the oxide layer formed on the surface of a handle wafer.

In some example implementations, bonding the first device material layer on the surface of the support wafer to the oxide layer formed on the surface of the handle wafer 330 may further involve heat treating the assembly of the silicon wafer and the handle wafer. The assembly of the support wafer and the handle wafer may be heat treated (e.g., at a temperature between about 600 °C and 1200 °C) to strengthen a bond between the first device material layer and the oxide layer formed on the surface of handle wafer.

Method 300 may further include removing a portion of the support wafer to reduce a thickness of the support wafer in the assembly (340). This removal of the portion of the support wafer may involve back grinding (or etching) and polishing processes. The resulting assembly may include the handle wafer, the oxide layer formed on the surface of a handle, the first device material layer (epitaxial layer) bonded to the oxide layer formed on the surface of a handle wafer, and a portion of the support wafer (CZ grown silicon wafer). The back grinding (or etching) and polishing processes may result in a controllably reduced combined thickness of the first device material layer and the back grinded (and polished) support wafer. The support wafer thickness remaining in the assembly may be determined by a depth required for depletion in devices (e.g., high performance CMOS device) fabricated in SOI substrate 100. In example implementations, the thickness of the support wafer (combined with the thickness of the first device layer) remaining in the assembly, may be reduced to, for example, a micron to a few tens of microns (e.g., 13.0 µm +/- 0.7 µm) to support a depletion region of a 200 V device.

Method 300 may further include growing a second device material layer on a top surface of the support wafer in the assembly (350). The top surface of the support wafer in the assembly may be a surface that is polished at the preceding step. The second device material layer may, for example, be an epitaxial silicon layer (e.g., layer 106-3, FIG. 1). In some example implementations, the epitaxial silicon layer may be a boron doped p-type layer with a resistivity of about 3 to 5 Ω.cm and a dopant concentration of about 2.7 E¹⁵ atoms/cm³. This second device material layer may be referred to herein as the second epitaxial silicon layer. The second epitaxial silicon layer may have a thickness of about a few microns (e.g., 4.0 µm +/- 0.7 µm).

FIGS. 4A through 4G schematically illustrate a SOI substrate assembly (e.g., SOI substrate 200, FIG. 2) at different stages of construction or after the different steps of method 300 for fabricating a SOI substrate. FIGS. 4A through 4G show cross-sectional views of the example SOI substrate at the different stages of construction.

FIG. 4A shows an example support wafer (e.g., support wafer 410) and FIG. 4B shows an example handle wafer (e.g., handle wafer 420) that are included in SOI substrate 200 (FIG. 4G).

Support wafer 410 may be a silicon substrate including compensated silicon semiconductor material (e.g., Czochralski material (CM)). Handle wafer 420 may be silicon wafer (e.g., a ≥ 200 mm diameter silicon wafer). Handle wafer 420 may be a p-doped silicon wafer. In example implementations, handle wafer 420 may include an n-doped layer 424 adjacent to its top surface.

At the next stage of construction, as shown in FIG. 4C, an epitaxial silicon layer (e.g., layer 412, epitaxial layer 1) is grown on support wafer 410, and as shown in FIG. 4D, a layer of oxide (e.g., layer 422) (e.g., a thermal oxide) is grown on handle wafer 420. The layer of oxide (e.g., layer 422) may form the buried oxide layer (BOX) in the SOI substrate 100 (FIG. 4G). The epitaxial silicon layer (e.g., layer 412) grown on support wafer 410 may, for example, be a p-doped layer. Layer 412 may form an anti-back gate (ABG) layer for devices fabricated in or on the SOI substrate. The epitaxial silicon layer (e.g., layer 412, epitaxial layer 1) may be referred to herein as the first epitaxial silicon layer. In example implementations, the first epitaxial silicon layer may have a thickness between 1 µm and 6 µm (e.g., between 2 µm and 4 µm).

At a next stage of construction, as shown in FIG. 4E, the support wafer 410 is bonded to the handle wafer 420. In a bonding process, the support wafer may be flipped (e.g., in the z direction) and placed upside down on the handle wafer so that the epitaxial silicon layer (e.g., layer 412) on the support wafer is in contact with the layer of oxide (e.g., layer 422) on the handle wafer. The epitaxial silicon layer (e.g., layer 412) on the support wafer is then bonded to the layer of oxide (e.g., layer 422) on the handle wafer, for example, by a heat treatment.

At a next stage of construction, a portion of the support wafer may be removed (e.g., by back grinding and polishing) so that a remaining portion of the support wafer has a desired thickness (e.g., thickness Tc). The thickness Tc may match requirements for supporting a depletion layer of a device to be fabricated in the SOI substrate. In example implementations, Tc may, for example, be about 10 µm to support a depletion region of a 200V device fabricated in the SOI substrate.

Further, at a next stage of construction, another epitaxial silicon layer (e.g., layer 414, epitaxial layer 2) is grown on support wafer 410. This epitaxial silicon layer (e.g., layer 414, epitaxial layer 2) can be the active area for devices and circuits fabricated in or on a thick SOI substrate (e.g., SOI substrate 100). The epitaxial silicon layer (e.g., layer 414, epitaxial layer 2) may be referred to herein as the second epitaxial silicon layer. In example implementations, the second epitaxial silicon layer may have a thickness between 1 µm and 10 µm (e.g., between 2 µm and 4 µm).

In example implementations, a device layer (e.g., layer 106, FIG. 1 and FIG. 2) of the SOI substrate includes the epitaxial silicon layer (e.g., layer 412, epitaxial layer 1) grown on support wafer 410, the remaining compensated material portion of the support wafer of thickness (e.g., thickness T_{c}) after grinding and polishing, and the epitaxial silicon layer (e.g., layer 414, epitaxial layer 2) grown on support wafer 410.

The various implementations described herein are given only by way of example and only for purposes of illustration. It will be understood, for purposes of this disclosure, that when an element, such as a layer, a region, a component, or a substrate, is referred to as being on, mechanically connected to, electrically connected to, coupled to, or electrically coupled to another element, it may be directly on, connected or coupled to the other element, or one or more intervening elements may be present. In contrast, when an element is referred to as being directly on, directly connected to or directly coupled to another element or layer, there are no intervening elements or layers present. Although the terms directly on, directly connected to, or directly coupled to may not be used throughout the detailed description, elements that are shown as being directly on, directly connected or directly coupled can be referred to as such. The claims of the application may be amended to recite exemplary relationships described in the specification and or shown in the figures.

As used in this specification, a singular form may, unless indicating a particular case in the context, include a plural form. Spatially relative terms (e.g., over, above, upper, under, beneath, below, lower, and so forth) are intended to encompass different orientations of the device in use or operation in addition to the orientation depicted in the figures. In some implementations, the relative terms above and below can, respectively, include vertically above and vertically below. In some implementations, the term adjacent can include laterally adjacent to or horizontally adjacent to.

Some implementations may be implemented using various semiconductor processing and/or packaging techniques. Some implementations may be implemented using various types of semiconductor processing techniques associated with semiconductor substrates including, but not limited to, for example, silicon (Si), silicon carbide (SiC), gallium arsenide (GaAs), gallium nitride (GaN), and/or so forth.

While certain features of the described implementations have been illustrated as described herein, many modifications, substitutions, changes, and equivalents will now occur to those skilled in the art. It is, therefore, to be understood that the appended claims are intended to cover all such modifications and changes as fall within the scope of the implementations. It should be understood that they have been presented by way of example only, not limitation, and various changes in form and details may be made. Any portion of the apparatus and/or methods described herein may be combined in any combination, except mutually exclusive combinations. The implementations described herein can include various combinations and/or subcombinations of the functions, components and/or features of the different implementations described.

## Claims

1. A semiconductor substrate, comprising:
a handle wafer;
an oxide layer on the handle wafer; and
a device layer on the oxide layer, the device layer including:
a first epitaxial silicon layer bonded to the oxide layer;
a layer of compensated silicon crystalline material on the first epitaxial silicon layer, the layer of compensated silicon crystalline material including a Czochralski silicon substrate; and
a second epitaxial silicon layer on the layer of compensated silicon crystalline material.

2. The semiconductor substrate of claim 1, wherein the oxide layer on the handle wafer is a thermally grown silicon dioxide layer with a thickness between 20 nm and 2000 nm.

3. The semiconductor substrate of claim 1, wherein the handle wafer includes an n-doped layer disposed below the oxide layer, wherein the first epitaxial silicon layer is a p-doped silicon layer having a thickness between 2 µm and 4 µm, wherein the layer of compensated silicon crystalline material has a thickness between about 8 µm and 12 µm, and
wherein the second epitaxial silicon layer has a thickness between about 2 µm and 4 µm.

4. The semiconductor substrate of claim 1, wherein the Czochralski silicon substrate has a diameter of 200 mm and is substantially free of crystalline originated particle (COP) defects.

5. A semiconductor substrate, comprising:
a handle wafer;
an oxide layer on the handle wafer; and
a device layer on the oxide layer, the device layer including a layer of compensated silicon crystalline material, the layer of compensated silicon crystalline material including a Czochralski silicon substrate.

6. The semiconductor substrate of claim 5, wherein the Czochralski silicon substrate is free of crystalline originated particle (COP) defects.

7. The semiconductor substrate of claim 6, wherein the Czochralski silicon substrate has a COP density of less than <1 COPs at 0.06 µm/cm².

8. The semiconductor substrate of claim 7, wherein the Czochralski silicon substrate has a radial resistivity variation of less than 3.5%.

9. A method, comprising:
forming an oxide layer on a surface of a handle wafer;
forming a first device material layer on a first surface of a support wafer, the support wafer being a Czochralski-grown silicon substrate;
bonding the first device material layer on the first surface of the support wafer to the oxide layer on the surface of the handle wafer to form an assembly including the support wafer and the handle wafer;
removing a portion of the support wafer to reduce a thickness of the support wafer in the assembly; and
forming a second device material layer on a second surface of the support wafer in the assembly.

10. The method of claim 9, wherein forming the first device material layer on the first surface of the support wafer includes epitaxially growing a silicon layer.

11. The method of claim 9, wherein removing a portion of the support wafer to reduce a thickness of the support wafer includes back grinding and polishing the support wafer to the reduced thickness.

12. The method of claim 9, wherein growing the second device material layer on the second surface of the support wafer in the assembly includes growing an epitaxial silicon layer.

13. The method of claim 9, wherein the surface of the handle wafer is a top surface, and wherein the method further comprises forming a polysilicon layer on a back surface of the handle wafer.

14. The method of claim 9, wherein the Czochralski-grown silicon substrate is free of crystalline originated particle (COP) defects, with a COP density of less than <1 COPs at 0.06 µm/cm².

15. The method of claim 14, wherein the Czochralski-grown silicon substrate has a diameter of 200 mm and a radial resistivity variation of less than 3.5%.
